# EUROPEAN PATENT APPLICATION

(11) **EP 1 256 981 A1**
(43) Date of publication of application: **13.11.2002**
(21) Application number: 02252407.8
(22) Date of filing: 03.04.2002
(51) Int. Cl.: H01L 23/495, C23C 28/02

(54) **Metal article coated with near-surface doped tin or tin alloy**

(30) Priority: 11.05.2001 US 853799
(71) Applicant: LUCENT TECHNOLOGIES INC., Murray Hill, New Jersey 07974-0636 (US)
(72) Inventor: Abys, Joseph Anthony, Warren, New Jersey 07059 (US); Fan, Chonglun, Bridgewater, New Jersey 08807 (US); Xu, Chen, New Providence, New Jersey 07974 (US); Zhang, Yun, Warren, New Jersey 07059 (US)
(74) Representative: Buckley, Christopher Simon Thirsk

(57) **Abstract**

In accordance with the invention, a metal substrate is coated with a layer of tin or tin alloy that is surface doped to inhibit the growth of tin whiskers. An optional metal underlayer may be disposed between the substrate and the tin. In an exemplary embodiment the metal substrate comprises copper alloy coated with a nickel underlayer and a layer of surface doped with gold or palladium tin. The doping inhibits whisker growth, and the resulting structure is particularly useful as an electrical connector or lead frame.

## Description

### FIELD OF THE INVENTION

This invention relates to metal articles plated for solderability and protection from corrosion. In particular, it concerns an article having a finish comprising a layer of tin or tin alloy that is surface doped to inhibit the growth of tin whiskers. The surface finish is especially useful for electrical connectors and integrated circuit lead frames.

### BACKGROUND OF THE INVENTION

High quality connectors are increasingly important in a wide variety of products including consumer electronics, household appliances, computers, automobiles, telecommunications, robotics and military equipment. Connectors provide the paths whereby electrical current flows from one device to another. Quality connectors should be highly conductive, corrosion resistant, wear resistant, readily connected by solder and inexpensive.

Unfortunately no single material has all the desired characteristics. Copper and many of its alloys are highly conductive, but they are subject to corrosion in typical ambients, producing reactive oxides and sulfides. The reactive corrosion products reduce the conductivity of the connectors and the reliability of interconnection. The corrosion products also interfere with the formation and reliability of solder bonds and can migrate to other electronic components which they adversely affect.

Thin layers of tin have been applied to copper surfaces to provide corrosion resistance and solderability. Tin is easily applied, non-toxic, provides corrosion protection and has excellent solderability. Unfortunately tin coatings are subject to spontaneous growth of metallic filaments called tin "whiskers". These whiskers have been identified as a cause of short circuit failures in low voltage equipment. Moreover whisker fragments can detach and accumulate within device packages, causing shorts at locations remote from their origin and interfering with electromechanical operation. Accordingly, it would be advantageous to provide metal articles with whisker free coatings of tin.

### SUMMARY OF THE INVENTION

In accordance with the invention, a metal substrate is coated with a layer of tin or tin alloy that is surface doped to inhibit the growth of tin whiskers. An optional metal underlayer may be disposed between the substrate and the tin. In an exemplary embodiment the metal substrate comprises copper alloy coated with a nickel underlayer and a layer of surface doped with gold or palladium tin. The doping inhibits whisker growth, and the resulting structure is particularly useful as an electrical connector or lead frame.

### BRIEF SUMMARY OF THE DRAWINGS

The advantages, nature and various additional features of the invention will appear more fully upon consideration of the illustrative embodiments now to be described in detail in connection with the accompanying drawings:
Fig. 1 is a schematic cross section of a metal article coated in accordance with the invention;
Fig. 2 is a block diagram showing the steps involved in making the coated metal article of Fig. 1;
Fig. 3 shows a substrate for making an electrical connector using the process of Fig. 2;
Figs. 4A and 4B illustrate typical surface-doping profiles; and
Fig. 5 shows a substrate for making an integrated circuit lead frame.

It is to be understood that these drawings are for purposes of illustrating the concepts of the invention and are not to scale.

### DETAILED DESCRIPTION

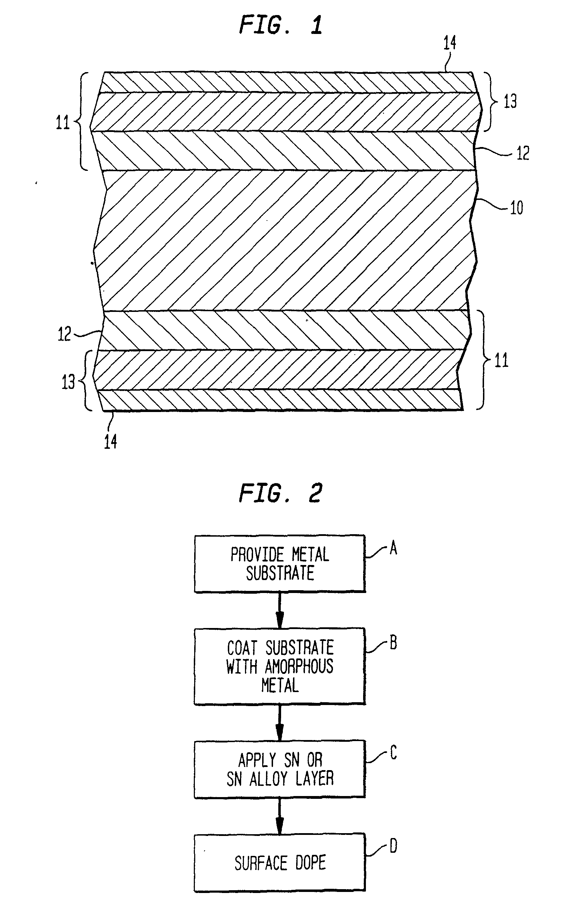

Fig. 1 is a schematic cross section of a metal substrate 10 coated with a finish 11 including an optional metal underlayer 12 and a layer 13 of tin or a tin alloy that is near-surface doped to inhibit whisker formation. A layer of tin or tin alloy that is near-surface doped has at least half the dopants between the surface and a depth of about 10% of the thickness of the layer. The metal substrate is typically a conductive metal such as copper, copper alloy, iron or iron alloy subject to corrosion in typical ambients. The optional underlayer is advantageously a low porosity metal such as nickel, nickel alloy, cobalt or cobalt alloy. It is preferably an amorphous alloy. Nickel-phosphorus alloy with phosphorus ≥ about 10 wt % is satisfactory for substrates comprising copper or iron. Nickel-phosphorus-tungsten or colbalt-phosphorus can also be used. The intermediate layer 13 can be tin or a tin alloy subject to whisker growth such as tin-copper, tin-bismuth, tin-silver, tin-nickel, tin-zinc or tin-copper-silver. The layer 13 is surfaced doped with a dopant which inhibits whisker formation. The optional underlayer 12 can have a thickness in the range of 0 - 5 µm. The layer 13 typically has a thickness in the range 0.5 - 10µm.

The layer 13 is advantageously near-surface doped by thermal or ion-assisted interdiffusion. A layer of the dopant is deposited on the tin layer by electroplating, PVD or CVD and the coated is heated to diffuse the dopant into the near surface region of layer 13 (typically the first 100 nm of the surface). Diffusion at 50° C for several hours has been effective. It is believed that this doping releases internal stress (the driving force for whiskers growth) and interrupts the mass transport of tin atoms by increasing the diffusion activation energy. The selective doping of only the near surface region 14 will sufficiently modify the surface and near-surface properties of the layer 13 to reduce the whisker growth without compromising the physical and chemical properties of the tin or tin alloy layer required for a solderable coating.

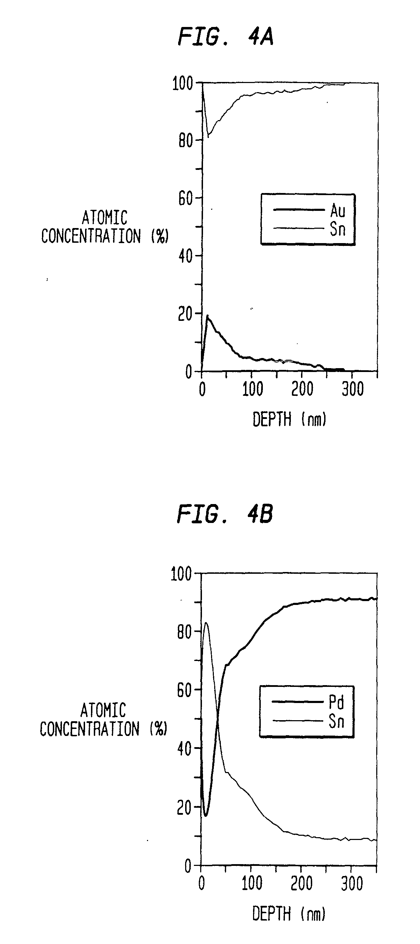

To test this method, applicants plated copper substrate with 3 µm tin films. A first subset of the samples was surface doped with gold, and a second subset was surface doped with palladium. Figs. 4A and 4B show the concentration profiles. As can be seen, most of the Au and Pd was found within the first 100 nm of the surface, less than 5% of the Sn film thickness.

The surface-doped S*n* films were then subjected to thermal aging at 50° C. No significant whisker growth was observed after 6 months of thermal aging.

The invention can be understood more clearly by consideration of the following specific examples describing the fabrication of coated metal articles in accordance with the invention.

### Example 1 - Electrical Connector

Fig. 2 is a block diagram of the steps in making a coated metal electrical connector. The first step, shown in Block A, is to provide a metal substrate. The substrate can be formed into a desired configuration as by stamping or etching a metal blank.

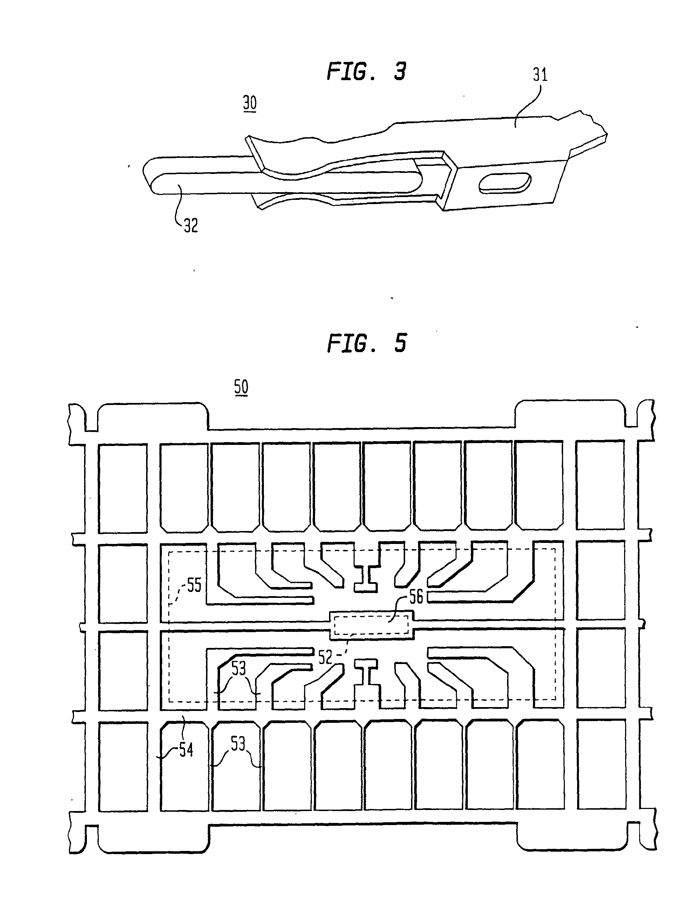

Fig. 3 illustrates a substrate for an electrical connector 30 having a connector body 31 and a mating pin 32. The connector 31 and the pin 32 are made of high conductivity metal such as copper-nickel-tin alloy No. 725 (88.2 wt. % Cu, 9.5 Ni, 2.3 Sn; ASTM Spec. No. B122).

The next step, which is optional, is to coat the conductive substrate 10 with a metal underlayer 12 such as amorphous nickel-phosphorus. The underlayer 12 can have a thickness from 0 to about 5 µm. It can be electrodeposited Ni-P with P content higher than about 10 wt % to assure amorphous structure. A suitable Ni-P amorphous layer can be electrodeposited using the following bath composition:

| | | |
|---|---|---|
| Nickel sulfate | NiSO₄6H₂O | 100-300 g/l |
| Nickel chloride | NiCl₂6H₂O | 40-60 g/l |
| Phosphorous acid | H₃PO₃ | 40-100 g/l |
| Phosphoric acid | H₃PO₄ | 0-50 g/l |

The third step, Block C, is to apply a layer 13 of tin or tin alloy. The layer 13 should have a thickness greater than about 0.5 µm and is preferably about 3 µm. A suitable tin layer can be electrodeposited using the following bath:

| | |
|---|---|
| Tin methane sulfonate | 40-80 g/l |
| Methane sulfonic acid | 100-200 g/l |
| Wetting Agent 300 | 5-15 g/l |
| (Harcos Chemicals Inc.) | |
| Anti-Oxidant C I | 1-3 g/l |

### (Spectrum Laboratory Products)

The next step, shown in Block D, is to surface dope the layer 13. Applicants have found that the proper choice of dopant will inhibit the growth of tin whiskers. The dopant can be precious metal such as palladium, gold, rhodium, ruthenium, platinum. It can also be copper, silver, or bismuth.

### Example 2 - Integrated Circuit Lead Frame

An integrated circuit lead frame can also be fabricated by the process illustrated in Fig. 2. The only differences are that the substrate is different and the tin coating thickness can be greater (e.g. 0.5 - 15 µm).

Fig. 5 illustrates a substrate 50 formed into configuration for use as a lead frame for an integrated circuit (IC). The substrate 50 includes a paddle 52 on which the IC is to be mounted and the leads 53 on which the IC is to be bonded. Dam bars 54 interconnect the leads before packaging. After the integrated circuit is bonded and a packaging medium has been applied over an area shown in phantom lines 55, the dam bars 54 are trimmed away.

The substrate of the lead frame can be copper or a copper alloy such as alloy No. 151 (99.9 wt. % Cu, 0.1% Zr) or alloy No. 194 (97.5 wt. % Cu, 2.35% Fe, 0.03% P, 0.12% Zn). Other conductive metals and alloys such as alloy No. 42 (42 wt. % Ni, 58% Fe) can also be used.

An integrated circuit 56 is mounted and bonded to the substrate and the substrate is by the process illustrated in Fig. 2. The result is an IC lead frame including a multilayer finish comprising surface doped tin or tin alloy.

It is to be understood that the above-described embodiments are illustrative of only a few of the many possible specific embodiments which can represent applications of the principles of the invention. Numerous and varied other arrangements can be readily devised by those skilled in the art without departing from the spirit and scope of the invention.

## Claims

1. A coated metal article comprising:
a metal substrate;
overlying the substrate a layer of tin or tin alloy having an outer surface and a thickness, the layer surface-doped with a dopant to inhibit the growth of whiskers from the layer, at least half of the dopant disposed between the surface and a depth of 10% of the thickness.

2. The article of claim 1 wherein the layer of tin or tin alloy is doped with a dopant selected from gold, palladium, rhodium, ruthenium, platinum, copper, silver, iridium or bismuth.

3. The article of claim 1 wherein the dopant is predominantly disposed within 100 nm of the surface of the tin or tin alloy layer.

4. The article of claim 1 further comprising an underlayer of metal selected from the group consisting of nickel, nickel alloy, cobalt and cobalt alloy.

5. The article of claim 1 wherein the underlayer is selected from the group consisting of nickel-phosphorus, nickel-phosphorus-tungsten and cobalt-phosphorus.

6. The article of claim 1 wherein the metal substrate comprises copper, copper alloy, iron, iron alloy, nickel or nickel alloy.

7. An electrical connector comprising a coated metal article in accordance with ciaim 1.

8. A lead frame for an integrated circuit comprising a coated metal article in accordance with claim 1.
